# EUROPÄISCHE PATENTSCHRIFT

(11) **EP 3 272 575 B1**
(45) Veröffentlichungstag und Bekanntmachung des Hinweises auf die Patenterteilung: **21.12.2022**
(21) Anmeldenummer: 17174915.3
(22) Anmeldetag: 08.06.2017
(51) Int. Cl.: H02J 7/00, B60L 58/19, B60L 58/21, H01M 10/44, G01R 31/00, G01R 31/396, H02J 1/06, H01M 10/42

(54) **TECHNIK ZUM BETRIEB EINES TRAKTIONSENERGIESPEICHERSYSTEMS**
METHOD FOR OPERATING A TRACTION ENERGY STORAGE SYSTEM
TECHNIQUE DE FONCTIONNEMENT D'UN SYSTÈME D'ACCUMULATION D'ÉNERGIE DE TRACTION

(30) Priorität: 29.06.2016 DE 102016007937
(43) Veröffentlichungstag der Anmeldung: 24.01.2018
(73) Patentinhaber: MAN Truck & Bus SE, 80995 München (DE)
(72) Erfinder: Mörtl, Alexander, 82110 Germering (DE); Nuber, Johannes, 85757 Karlsfeld (DE); Kirchensteiner, Elmar, 85256 Vierkirchen (DE); Antwerpen, Korbinian, 80807 München (DE); Froschermeier, Andreas, 80992 München (DE)
(74) Vertreter: v. Bezold & Partner Patentanwälte - PartG mbB

(56) Entgegenhaltungen:
- EP-A2- 2 493 050
- EP-A2- 2 712 045
- US-A1- 2004 138 785
- US-A1- 2014 117 756
- US-A1- 2015 194 707

## Beschreibung

Die vorliegende Erfindung betrifft eine Technik zum Betrieb eines Traktionsenergiespeichersystems mit mehreren parallelschaltbaren Energiespeichern. Insbesondere sind ein Verfahren zum Hinzuschalten eines oder mehrerer Energiespeicher zu einem Verbund parallelgeschalteter Energiespeicher sowie ein entsprechendes Traktionsenergiespeichersystem beschrieben.

Energiespeichersysteme sind aus der Solartechnik bekannt. Das Dokument US 2014/0117756 A1 beschreibt ein Energiespeichersystem mit Ladeschaltern, Entladeschaltern, einem bidirektionalen DC/DC-Wandler und einem Stromspeichersystem-Controller, der alle Zellmodule mit einem externen Stromkreis verbindet, um eine parallele Ladung und Entladung zu erreichen. Die Zellmodule werden nach einem bestimmten Verfahren vorgeladen.

Fahrzeuge mit elektrifiziertem Antriebsstrang gewinnen aufgrund Ihrer höheren Energieeffizienz und Umweltfreundlichkeit gegenüber konventionellen Fahrzeugen mehr und mehr an Bedeutung. Die von den elektrischen Antriebsmaschinen umgewandelte Energie wird üblicherweise aus elektrischen Energiespeichern zur Verfügung gestellt und in diesen gespeichert. Fahrzeuge mit einem hohen elektrischen Energiebedarf, insbesondere Nutzfahrzeuge wie Busse und Lastkraftwagen, benötigen Energiespeicher mit großen Kapazitäten. Um große Speicherkapazitäten bei gleichzeitig flexibler Skalierbarkeit und Integrierbarkeit in verschiedene Fahrzeugtypen zu erreichen, wird das Energiespeichersystem häufig modular ausgeführt. Hierbei werden mehrere Energiespeicher zu einem Energiespeicherverbund zusammen geschaltet.

Eine gängige Verschaltung von Energiespeichern zu einem Verbund stellt die Parallelschaltung dar, so dass die Energiespeicher des Verbunds eine einheitliche Systemspannung aufweisen. Jeder Energiespeicher ist mit Schaltschützen zur elektrischen Trennung ausgestattet. Aufgrund verschiedener Einflussfaktoren, wie z. B. Fertigungstoleranzen, unterschiedliches Alterungsverhalten oder thermische Belastung, kann es im Fahrzeugleben zu Abweichungen der Energieinhalte, und damit der internen Leerlaufspannungen der Energiespeicher kommen. Soll ein Energiespeicher mit dem Bordnetz verbunden werden, darf dessen interne Leerlaufspannung und die Systemspannung im Bordnetz eine gewisse Differenz nicht überschreiten. Diese Spannungsdifferenz treibt über die Innenwiderstände der zu verbindenden Energiespeicher einen Ausgleichsstrom, der im Moment des Verbindens die Schaltschütze belastet (Zuschaltstrom) und deren Lebensdauer beeinträchtigt. Im Falle stark abweichender Leerlaufspannungen ist damit ein Hinzuschalten des betroffenen Energiespeichers ohne ein Angleichen der Leerlaufspannungen nicht möglich.

Herkömmlicherweise wird zum Angleichen der Leerlaufspannungen im Betrieb eines verbindbaren Teilverbunds von Energiespeichern diesem Energie entnommen oder zugeführt, um die Leerlaufspannung des Teilverbunds der Leerlaufspannung des abgewichenen Energiespeichers anzugleichen. Sobald die Differenz der Leerlaufspannungen sehr gering geworden ist, kann der abgewichene Energiespeicher zugeschaltet werden, wobei der Laststrom vollständig oder nahezu vollständig auf null reduziert wird, um den Schaltstrom der Schaltschütze gering zu halten.

Das Dokument US 2015/0194707 A1 beschreibt ein solches herkömmliches System mit einer Vielzahl von Batterien und einer Batteriemanagementeinheit. Die Batterien sind so konfiguriert, dass sie über Modulschalter wahlweise parallelgeschaltet werden können. Die Batteriemanagementeinheit erfasst eine Modulspannung jeder Batterie und steuert die Modulschalter so, dass sie die Batterien in einer aufsteigenden Reihenfolge der Modulspannung von der Batterie mit der niedrigsten Modulspannung zur Batterie mit der höchsten Modulspannung in einem Ladebetrieb parallelschaltet. In einem Entladebetrieb werden die Modulschalter so gesteuert, dass sie die Batterien in einer absteigenden Reihenfolge der Modulspannung von der Batterie mit der höchsten Modulspannung zur Batterie mit der niedrigsten Modulspannung parallelschalten.

Für den Fahrzeugbetrieb bedeutet dies eine starke Einschränkung der zur Verfügung stehenden Leistung, z. B. für das elektrisch erzeugte Antriebsmoment. Die Länge des Zeitraums, in dem die Spannungsdifferenz hinreichend gering für den Schaltvorgang ist, ist zusätzlich durch den Leistungsbedarf des Fahrzeugs und den Energieinhalt des Teilverbunds begrenzt, falls keine weitere elektrische Energiequelle im Fahrzeug zur Verfügung steht. Der Zeitraum, in dem das Hinzuschalten möglich ist, kann deshalb beliebig kurz sein.

Dokument EP 2493050 A2 offenbart eine Schaltung und ein Verfahren zum Parallelschalten eines ersten elektrischen Speichers und eines zweiten elektrischen Speichers, wobei der erste elektrische Speicher und der zweite elektrische Speicher jeweils eine Leerlaufspannung und eine Impedanz besitzen und Anschlussklemmen zur Ladungsentnahme oder Ladungszufuhr aufweisen. Die Leerlaufspannung des ersten Speichers ist größer als die Leerlaufspannung des zweiten Speichers. Bei Ladungsentnahme wird zunächst nur dem ersten Speicher Ladung entnommen und der zweite Speicher wird parallel zu dem ersten Speicher geschaltet, wenn die Differenz der an den Anschlussklemmen des ersten Speichers abfallenden Spannung und der Leerlaufspannung des zweiten Speichers weniger als eine vorgegebene Zuschalt-Differenzspannung beträgt.

Somit ist es eine Aufgabe der vorliegenden Erfindung, eine Technik zum Betrieb eines modular aufgebauten Energiespeichersystems bereitzustellen, bei der das Hinzuschalten eines Energiespeichers die Fahrzeugnutzung nicht oder in geringerem Umfang einschränkt. Eine alternative oder zusätzliche Aufgabe ist, eine Technik zum Betrieb eines modular aufgebauten Energiespeichersystems bereitzustellen, welche die Häufigkeit einer Zuschaltmöglichkeit verbessert, oder bei der mit durchschnittlich weniger Zeitverzögerung das Hinzuschalten erfolgt.

Diese Aufgabe oder Aufgaben werden durch eine Technik mit den Merkmalen der unabhängigen Ansprüche gelöst. Vorteilhafte Ausführungsformen und Anwendungen der Erfindung sind Gegenstand der abhängigen Ansprüche und werden in der folgenden Beschreibung unter teilweiser Bezugnahme auf die Figuren näher erläutert.

Gemäß einem Aspekt der Erfindung ist ein Verfahren zum Betrieb eines Traktionsenergiespeichersystems eines Fahrzeugs mit mehreren parallelschaltbaren Energiespeichern bereitgestellt. Eine Teilmenge der Energiespeicher ist parallelgeschaltet und mindestens ein hinzuzuschaltender Energiespeicher ist nicht mit der parallelgeschalteten Teilmenge parallelgeschaltet. Das Verfahren umfasst einen Schritt des Bestimmens eines Innenwiderstands der parallelgeschalteten Teilmenge der Energiespeicher, einer Leerlaufspannung der parallelgeschalteten Teilmenge der Energiespeicher und einer Leerlaufspannung des mindestens einen hinzuzuschaltenden Energiespeichers; einen Schritt des Steuerns eines Stroms durch die parallelgeschaltete Teilmenge der Energiespeicher, der so bemessen ist, dass die Leerlaufspannung der parallelgeschalteten Teilmenge der Energiespeicher und ein durch den Strom und den Innenwiderstand bewirkter Spannungsabfall eine Spannung der parallelgeschalteten Teilmenge der Energiespeicher ergeben, die von der Leerlaufspannung des mindestens einen hinzuzuschaltenden Energiespeichers um weniger als eine vorbestimmte Schaltspannung abweicht; und einen Schritt des Parallelschaltens des mindestens einen hinzuzuschaltenden Energiespeichers mit der parallelgeschalteten Teilmenge der Energiespeicher während die Spannung der parallelgeschalteten Teilmenge der Energiespeicher von der Leerlaufspannung des mindestens einen hinzuzuschaltenden Energiespeichers um weniger als die vorbestimmte Schaltspannung abweicht.

Indem der Schritt des Steuerns bewirkt, dass die Spannung der parallelgeschalteten Teilmenge der Energiespeicher von der Leerlaufspannung des mindestens einen hinzuzuschaltenden Energiespeichers um weniger als die vorbestimmte Schaltspannung abweicht, kann beim Schritt des Parallelschaltens Verschleiß an Schaltkontakten von Schaltschützen aufgrund zu hoher Spannungsdifferenzen und Schaltströme vermieden werden.

Indem der Strom gezielt so gesteuert wird, dass die Bedingung für den Schritt des Parallelschaltens erfüllt ist, kann eine Häufigkeit der Möglichkeiten zum Parallelschalten erhöht werden. Dadurch ist ein zeitnahes und/oder die Nutzung des Traktionsenergiespeichersystem weniger störendes Schalten ermöglicht. Die Nutzung kann einen Fahrbetrieb und/oder einen Ladebetrieb umfassen. Ferner kann die Technik in Vorbereitung der Nutzung eingesetzt werden. Die Technik kann im Stand und/oder bei abgeschaltetem Fahrzeug (beispielsweise spannungslosem Zündkontakt) oder abgeschaltetem Antriebsstrang eingesetzt werden.

Der Strom kann über eine Verbindung zu einem Netz des Fahrzeugs (beispielsweise einem Hochvolt-Netz des Fahrzeugs) fließen. Der Strom kann beispielsweise durch einen Signalaustausch zwischen einer Steuerung des Fahrzeug-Netzes und einer Steuerung des Traktionsenergiespeichersystems gesteuert werden.

Die Teilmenge der parallelgeschalteten Energiespeicher wird auch als Verbund der Energiespeicher, nutzbarer Teil der Energiespeicher oder aktiver Teil der Energiespeicher bezeichnet.

Der Schritt des Bestimmens kann ein Schätzen, beispielsweise ein Extrapolieren oder eine Ausgleichsrechnung, umfassen.

Das Verfahren (insbesondere das Steuern des Stroms) kann vollständig in einer Steuerung des Traktionsenergiespeichersystems (beispielsweise einer Steuerung, die auch das Parallelschalten steuert) implementiert sein. Alternativ oder ergänzend kann das Verfahren (insbesondere das Steuern des Stroms) vollständig in einer Steuerung des Fahrzeugs (beispielsweise einer Steuerung, die auch ein Umrichten der Gleichspannung in eine Wechselspannung steuert) implementiert sein. Alternativ oder ergänzend kann das Verfahren (insbesondere das Steuern des Stroms) teilweise in der Steuerung des Traktionsenergiespeichersystems und teilweise in der Steuerung des Fahrzeugs implementiert sein.

Das Traktionsenergiespeichersystem kann eine Leistungsschnittstelle umfassen. Die Spannung der parallelgeschalteten Teilmenge der Energiespeicher kann an der Leistungsschnittstelle anliegen. Die parallelgeschalteten Energiespeicher können jeweils mit einem Pluspol und einem Minuspol der Leistungsschnittstelle des Traktionsenergiespeichersystems verbunden sein.

Der gesteuerte Strom kann durch die Leistungsschnittstelle fließen. Die Spannung der parallelgeschalteten Teilmenge der Energiespeicher, beispielsweise die Spannung an der Leistungsschnittstelle des Traktionsenergiespeichersystems, wird auch als Systemspannung oder Verbundspannung bezeichnet. Die Leistungsschnittstelle des Traktionsenergiespeichersystems kann eine Gleichspannungsschnittstelle sein. Die Leistungsschnittstelle des Traktionsenergiespeichersystems kann mit einem Gleichspannungszwischenkreis verbunden oder verbindbar sein.

Alternativ oder ergänzend können die Energiespeicher der parallelgeschalteten Teilmenge über ein Bordnetz elektrisch miteinander zu einem Gleichspannungszwischenkreis verbunden sein. Das Bordnetz kann dazu ausgebildet sein, elektrische Aggregate des Fahrzeugs zur Leistungsabgabe und/oder zur Leistungsaufnahme zu verbinden.

Der Strom durch die Leistungsschnittstelle des Traktionsenergiespeichersystems oder das Bordnetz kann vor, während und/oder nach dem Schritt des Parallelschaltens von Null verschieden sein.

Erfindungsgemäß umfasst das Verfahren ferner einen Schritt des Bestimmens eines Betriebsmodus des Fahrzeugs. Bei einem vom Traktionsenergiespeichersystem (beispielsweise hauptsächlich und/oder im Zeitmittel) Energie entnehmenden Betriebsmodus (z. B. einem Betriebsmodus zum Fahren oder einer Netz-Rückspeisung an einer Ladeinfrastruktur) ist die Leerlaufspannung der parallelgeschalteten Teilmenge größer als die Leerlaufspannung des mindestens einen hinzuzuschaltenden Energiespeichers. Alternativ oder ergänzend ist bei einem dem Traktionsenergiespeichersystem (beispielsweise hauptsächlich und/oder im Zeitmittel) Energie zuführenden Betriebsmodus (z. B. einem Betriebsmodus zum Laden oder einer Rekuperation durch Bremsen) die Leerlaufspannung der parallelgeschalteten Teilmenge kleiner als die Leerlaufspannung des mindestens einen hinzuzuschaltenden Energiespeichers.

Das Zuschalten in Abhängigkeit vom Betriebsmodus kann (beispielsweise in einem ersten Verfahrensabschnitt) zur Anpassung der Leerlaufspannung und/oder zum systemstromfreien Zuschalten eingesetzt werden. Alternativ oder ergänzend kann das Zuschalten in Abhängigkeit vom Betriebsmodus (beispielsweise in einem zweiten Verfahrensabschnitt nach dem ersten Verfahrensabschnitt) zur Anpassung der Systemspannung eingesetzt werden.

Die Steuerung des Stroms kann Zustände während und/oder nach dem Schritt des Parallelschaltens berücksichtigen. Beispielsweise kann während des Schritts des Parallelschaltens eine Differenz zwischen der Spannung der parallelgeschalteten Teilmenge der Energiespeicher und der Leerlaufspannung des mindestens einen hinzuzuschaltenden Energiespeichers berücksichtigt werden. Alternativ oder ergänzend kann ein nach dem Schritt des Parallelschaltens erwarteter Ausgleichsstrom zwischen der bisherigen parallelgeschalteten Teilmenge der Energiespeicher und dem mindestens einen hinzugeschalteten Energiespeicher berücksichtigt werden.

Die Ausführung zumindest des Schritts des Steuerns und/oder des Schritts des Parallelschaltens kann an eine erste Zuschaltbedingung geknüpft sein. Die erste Zuschaltbedingung kann voraussetzen, dass die Leerlaufspannung der parallelgeschalteten Teilmenge von der Leerlaufspannung des mindestens einen hinzuzuschaltenden Energiespeichers um weniger als eine vorbestimmte Leerlaufspannungsdifferenz abweicht.

Die Bedingung des Schritts des Parallelschaltens, dass die Spannung der parallelgeschalteten Teilmenge der Energiespeicher von der Leerlaufspannung des mindestens einen hinzuzuschaltenden Energiespeichers um weniger als die vorbestimmte Schaltspannung abweicht, wird auch als zweite Zuschaltbedingung bezeichnet.

Die vorbestimmte Leerlaufspannungsdifferenz kann größer als die vorbestimmte Schaltspannung sein.

Der Schritt des Steuerns des Stroms kann die Spannung der parallelgeschalteten Teilmenge der Energiespeicher auf die Leerlaufspannung des mindestens einen hinzuzuschaltenden Energiespeichers regeln. Dabei kann der Strom eine Steuergröße oder eine Stellgröße sein, die Spannung der parallelgeschalteten Teilmenge eine Regelgröße sein, und/oder die Leerlaufspannung des mindestens einen hinzuzuschaltenden Energiespeichers eine Ziel- oder Führungsgröße sein.

Der Strom kann während einer Zeitspanne gesteuert werden. Die Spannung der parallelgeschalteten Teilmenge kann während der Zeitspanne geregelt werden. Die Zeitspanne kann den Schritt des Parallelschaltens vollständig umfassen. Die Zeitspanne kann größer als 50 ms und/oder kleiner als 500 ms sein. Beispielsweise kann die Zeitspanne zwischen 200 ms und 400 ms betragen.

Der Strom kann gesteuert werden, indem ein mittels des Stroms bewirktes Antriebsmoments des Fahrzeugs verändert oder verzögert wird. Die Veränderung oder die Verzögerung kann eine Abweichung gegenüber einer durch eine Anforderung des Fahrers (beispielsweise eine Gaspedalstellung) vorgegebene Stromsteuerung sein. Das mit dem Strom bewirkte Antriebsmoment kann außerhalb der Zeitspanne der Fahreranforderung entsprechen. Während der Zeitspanne kann das durch den gesteuerten Strom bewirkte Antriebsmoment von einer Fahreranforderung abweichen.

Erfindungsgemäß wird der Strom gesteuert, indem eine Leistungsversorgung eines Nebenverbrauchers verändert wird. Der Nebenverbraucher wird aus der parallelgeschalteten Teilmenge der Energiespeicher gespeist.

Der gesteuerte Strom kann ein Laststrom und/oder ein Ladestrom sein.

Im Fall des Laststroms kann die Spannung der parallelgeschalteten Teilmenge (beispielsweise eine Nutzspannung) kleiner sein als die Leerlaufspannung der parallelgeschalteten Teilmenge. Dies kann durch einen Spannungsabfall am Innenwiderstand gegenüber der Leerlaufspannung der parallelgeschalteten Teilmenge erreicht werden. Alternativ oder ergänzend kann die Leerlaufspannung des mindestens einen hinzuzuschaltenden Energiespeichers kleiner sein als die Leerlaufspannung der parallelgeschalteten Teilmenge. Beispielsweise kann, bezüglich der Leerlaufspannung der parallelgeschalteten Teilmenge, die Leerlaufspannung des mindestens einen hinzuzuschaltenden Energiespeichers die nächstkleinere Leerlaufspannung bzw. die nächst-kleineren Leerlaufspannungen sein unter den noch nicht mit der Teilmenge parallelgeschalteten Energiespeichern des Traktionsenergiespeichersystems.

Im Fall des Ladestroms kann die Spannung der parallelgeschalteten Teilmenge (beispielsweise eine Ladespannung) größer als die Leerlaufspannung der Teilmenge sein. Dies kann durch einen Spannungsabfall am Innenwiderstand gegenüber der Ladespannung erreicht werden. Alternativ oder ergänzend kann die Leerlaufspannung des mindestens einen hinzuzuschaltenden Energiespeichers größer sein als die Leerlaufspannung der parallelgeschalteten Teilmenge. Beispielsweise kann, bezüglich der Leerlaufspannung der parallelgeschalteten Teilmenge, die Leerlaufspannung des mindestens einen hinzuzuschaltenden Energiespeichers die nächst-größere Leerlaufspannung bzw. die nächst-größeren Leerlaufspannungen sein unter den noch nicht mit der Teilmenge parallelgeschalteten Energiespeichern des Traktionsenergiespeichersystems.

Die zum jeweiligen Zeitpunkt (beispielsweise vor oder nach dem Schritt des Parallelschaltens) parallelgeschalteten Energiespeicher (beispielsweise die Teilmenge bzw. die Teilmenge zuzüglich des mindestens einen zugeschalteten Energiespeichers) können den nutzbaren Teil des Energiespeichersystems bilden.

Das Verfahren kann implementiert werden zum Hinzuschalten von in ihrem Ladezustand (auch: "State of Charge" oder SOC) und/oder ihrer Leerlaufspannung (auch: "Open Circuit Voltage" oder OCV) im Vergleich zur parallelgeschalteten Teilmenge (d. h. dem gegenwärtig nutzbaren Teil des Traktionsenergiespeichersystems) stark abgewichenen Energiespeichern. Insbesondere kann das Verfahren bei einem Traktionsenergiespeichersystem eingesetzt werden, bei dem aufgrund unterschiedlicher Spannungslagen das Hinzuschalten nicht ohne weiteres möglich ist.

Der Strom durch die Teilmenge der bereits parallelgeschalteten Energiespeicher (d. h. durch den gegenwärtig nutzbaren Teil des Traktionsenergiespeichersystems) kann in die Steuerung einbezogen werden (beispielsweise von der Steuerung geregelt und/oder überwacht werden), um einen gesteuerten Spannungsausgleich oder eine gesteuerte Spannungsanpassung zwischen der Spannung des Traktionsenergiespeichersystems und der Leerlaufspannung des mindestens einen hinzuzuschaltenden Energiespeichers zu erzielen.

Gemäß einem weiteren Aspekt der Erfindung ist ein Traktionsenergiespeichersystem eines Fahrzeugs bereitgestellt. Das Traktionsenergiespeichersystem umfasst mehrere parallelschaltbare Energiespeicher; und eine oder mehrere mit dem Fahrzeug in Signalaustausch stehende Steuerungen, die dazu ausgebildet sind, die Schritte oder Funktionen des vorgenannten Aspekts auszuführen, zu bewirken, zu steuern, zu überwachen und/oder ein Resultat des entsprechenden Schritts zu erhalten.

Das Traktionsenergiespeichersystem kann jedes im Zusammenhang mit dem Verfahrensaspekt genannte Merkmal umfassen. Das Traktionsenergiespeichersystem kann dazu ausgebildet sein, einen oder mehrere der Schritte oder Funktionen des vorgenannten Aspekts auszuführen. Alternativ oder ergänzend kann das Traktionsenergiespeichersystem eine oder mehrere funktionelle Einheiten umfassen, die zur Ausführung einzelner oder aller Schritte oder Funktionen des vorgenannten Aspekts ausgebildet sind.

Gemäß einem weiteren Aspekt ist ein Kraftfahrzeug, insbesondere ein Nutzfahrzeug, bereitgestellt, dessen Antriebsstrang ein Traktionsenergiespeichersystem gemäß dem vorstehenden Aspekt umfasst.

Weitere Merkmale und Vorteile der Erfindung werden im Folgenden unter Bezugnahme auf die beigefügten Zeichnungen beschrieben. Es zeigen:
- Figur 1: ein schematisches Blockschaltbild eines Traktionsenergiespeichersystems;
- Figur 2: ein Flussdiagramm für ein Verfahren zum Betrieb eines Traktionsenergiespeichersystems, das mit dem Traktionsenergiespeichersystem der Figur 1 implementierbar ist;
- Figur 3: schematisch eine Stromabhängigkeit und Bedingungen zum Hinzuschalten eines Traktionsenergiespeichers im Betriebsmodus "Fahren";
- Figur 4: schematisch eine Stromabhängigkeit und Bedingungen zum Hinzuschalten eines Traktionsenergiespeichers im Betriebsmodus "Laden";
- Figur 5: schematisch einen zeitlichen Verlauf einer Leerlaufspannung eines Traktionsenergiespeichersystems im Betriebsmodus "Fahren";
- Figur 6: schematisch einen zeitlichen Verlauf einer Leerlaufspannung eines Traktionsenergiespeichersystems im Betriebsmodus "Laden";

- Figur 7: schematisch einen zeitlichen Verlauf einer Spannung des Traktionsenergiespeichersystems, welcher die Ausführung von Schritten des Verfahrens auslöst;
- Figur 8: schematisch eine erste Implementierung des Verfahrens der Figur 3;
- Figur 9: schematisch eine zweite Implementierung des Verfahrens der Figur 3;
- Figur 10: schematisch ein erstes Beispiel zur Stromsteuerung, das in einem der Verfahren der Figur 3, 8 oder 9 implementierbar ist;
- Figur 11: schematisch ein zweites Beispiel zur Stromsteuerung, das in einem der Verfahren der Figur 3, 8 oder 9 implementierbar ist; und
- Figur 12: schematisch ein drittes Beispiel zur Stromsteuerung, das in einem der Verfahren der Figur 3, 8 oder 9 implementierbar ist.

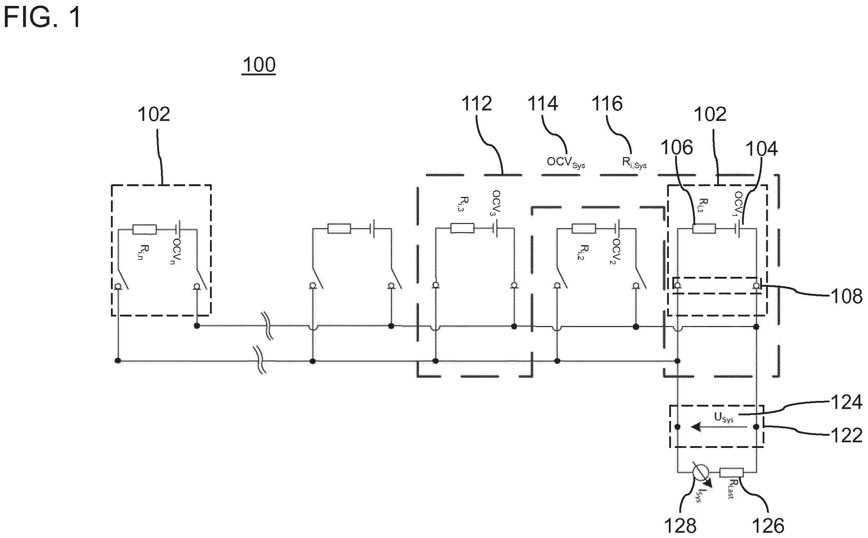

Figur 1 zeigt ein schematisches Blockschaubild eines Ausführungsbeispiels eines allgemein mit dem Bezugszeichen 100 bezeichnet Traktionsenergiespeichersystems (TES-System) für ein Fahrzeug. Das TES-System 100 umfasst eine Vielzahl an Traktionsenergiespeichern 102 (TES oder kurz: Energiespeicher). Das TES-System 100 kann deshalb auch als Multi-TES-System bezeichnet werden.

Jeder der mit j = 1, ..., n nummerierten TES 102 kann (beispielsweise zur näherungsweisen Beschreibung seiner elektrischen Eigenschaften) eine Gleichspannungsquelle mit einer (beim Bezugszeichen 104 dargestellten) Leerlaufspannung OCVⱼ und einen (beim Bezugszeichen 106 dargestellten) Innenwiderstand R_{i,j} umfassen.

Jeder TES 102 umfasst mindestens ein Schaltschütz 108, das in einer ersten Stellung das jeweilige TES 102 isoliert und in einer zweiten Stellung mit einem Gleichspannungszwischenkreis verbindet. Das in Figur 1 gezeigte Ausführungsbeispiel umfasst ein Schaltschütz 108, das beide Gleichspannungspole des jeweiligen TES 102 in der ersten Stellung vom Gleichspannungszwischenkreis trennt und in der zweiten Stellung mit dem Gleichspannungszwischenkreis verbindet.

Mittels der Schaltschütze 108 sind die TES 102 parallelschaltbar, beispielsweise über den Gleichspannungszwischenkreis. Die durch die zweite Stellung des jeweiligen Schaltschützes 108 parallelgeschalteten TES 102 bilden einen Energiespeicherverbund (oder kurz: Verbund), der auch als parallelgeschaltete Teilmenge 112 der TES 102 im TES-System 100, nutzbarer Teil der TES 102 oder aktiver Teil des TES-Systems 100 bezeichnet wird. Dem Verbund 112 ist zur Beschreibung seiner elektrischen Eigenschaften eine Leerlaufspannung 114 und ein Innenwiderstand 116 zugeordnet.

Das TES-System 100 umfasst ferner eine Leistungsschnittstelle 122 zum Fahrzeug. Eine Spannung 124 der parallelgeschalteten Teilmenge 112 liegt an der Leistungsschnittstelle 122 an. Die Leistungsschnittstelle 122 ist fahrzeugseitig beispielsweise mit einem Gleichstromaggregat (beispielsweise für eine Funktion im Stand des Fahrzeugs oder zum Betrieb eines Aufbaus des Nutzfahrzeugs) oder einem Inverter (beispielsweise zum Erzeugen einer mehrphasigen Wechselspannung für den Antriebsstrang des Fahrzeugs) verbunden. Dessen Eingangsseite ist im Blockschaltbild der Figur 1 beim Bezugszeichen 126 als (im Allgemeinen komplexwertiger) Widerstand R_{Last} dargestellt und entnimmt den beim Bezugszeichen 128 dargestellten Strom I_{Sys}. Der Strom 128 kann im TES-System 100 (beispielsweise durch Summieren der Teilströme jedes TES 102) und/oder fahrzeugseitig bestimmt werden.

Da nur die parallelgeschaltete Teilmenge 112 (d. h. der Verbund), beispielsweise über die Leistungsschnittstelle 108 und/oder den Gleichspannungszwischenkreis, am Energieaustausch mit dem Fahrzeug teilnimmt, können deren elektrische Eigenschaften die Eigenschaften des Traktionsenergiespeichersystems zum jeweiligen Zeitpunkt teilweise oder vollständig bestimmen. So kann der Innenwiderstand 116 des Verbunds 112 auch als Innenwiderstand 116 des TES-Systems 100, R_{i,Sys}, oder Systeminnenwiderstand 116 bezeichnet werden. Aus nämlichem Grund kann die Leerlaufspannung 114 des Verbunds 112 auch als Leerlaufspannung 114 des TES-Systems 100, OCV_{Sys}, oder Systemleerlaufspannung 114 bezeichnet werden. Die Spannung 124 (beispielsweise an der Leistungsschnittstelle 122) des Verbunds 112 kann auch als Spannung 124 des TES-Systems 100, U_{Sys}, oder Systemspannung 124 bezeichnet werden. Der Strom 128 durch den Verbund 112 (beispielsweise durch die Leistungsschnittstelle 122) kann auch als Strom 128 des TES-Systems 100, I_{Sys}, oder Systemstrom 128 bezeichnet werden.

Der Systeminnenwiderstand 116 kann im TES-System 100 oder fahrzeugseitig bestimmt werden, beispielsweise durch Summieren der Kehrwerte der Innenwiderstände der jeweiligen TES 102. Die Systemleerlaufspannung 114 kann in einem Nulldurchgang des Stroms 128 bestimmt werden. Alternativ oder ergänzend können Systemleerlaufspannung 114 und Systeminnenwiderstand 116 aus mehreren Messwertpaaren zu Systemspannung 124 und Systemstrom 128 extrapoliert oder durch lineare Regression bestimmt werden.

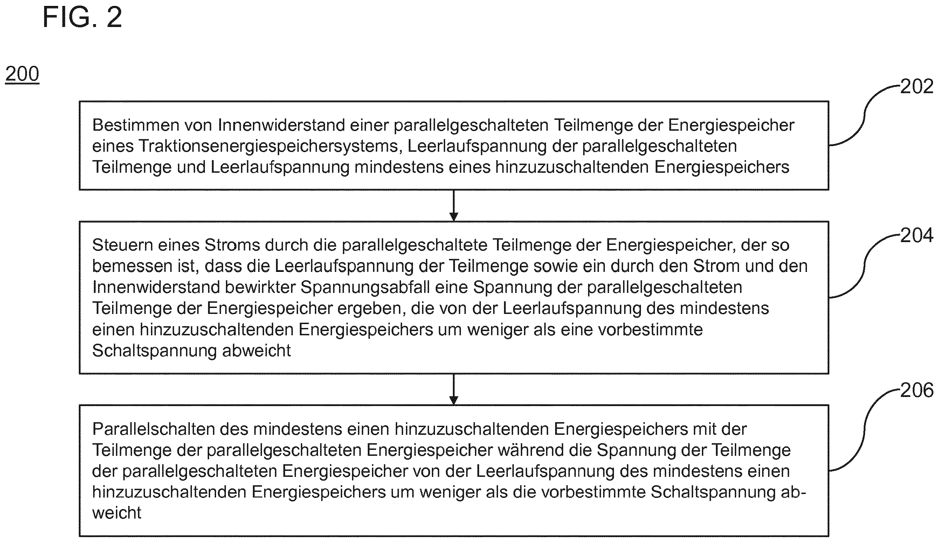

Figur 2 zeigt ein Flussdiagram eines allgemein mit Bezugszeichen 200 bezeichneten Verfahrens zum Betrieb eines TES-Systems 100 eines Fahrzeugs mit mehreren parallelschaltbaren TES 102, bei dem eine Teilmenge 112 der TES 102 parallelgeschaltet ist und mindestens ein hinzuzuschaltender TES 102 nicht mit der parallelgeschalteten Teilmenge parallelgeschaltet ist.

In einem Schritt 202 des Verfahrens 200 wird ein Innenwiderstand 116 der parallelgeschalteten Teilmenge 112 der TES 102, eine Leerlaufspannung 114 der parallelgeschalteten Teilmenge 112 der TES 102 und eine Leerlaufspannung des mindestens einen hinzuzuschaltenden TES 102 bestimmt.

In einem Schritt 204 wird ein Strom 128 durch die parallelgeschaltete Teilmenge 112 der TES 102 gesteuert. Die Leerlaufspannung 114 der parallelgeschalteten Teilmenge 112 der TES 102 und ein durch den gesteuerten Strom 128 und den Innenwiderstand 116 bewirkter Spannungsabfall setzten sich zur Spannung 124 der parallelgeschalteten Teilmenge 112 der TES 102 zusammen. Der gesteuerte Strom 128 ist, zumindest in einem Zeitabschnitt, so bemessen, dass die Spannung 124 der parallelgeschalteten Teilmenge 112 von der Leerlaufspannung des mindestens einen hinzuzuschaltenden TES 102 um weniger als eine vorbestimmte Schaltspannung abweicht.

Dadurch ist es in einem Schritt 206 des Verfahrens 200 möglich, den mindestens einen hinzuzuschaltenden TES 102 mit der parallelgeschalteten Teilmenge 112 der TES 102 parallelzuschalten während des Zeitabschnitts, in dem die Spannung 124 der parallelgeschalteten Teilmenge 112 der TES 102 von der Leerlaufspannung des mindestens einen hinzuzuschaltenden TES 102 um weniger als die vorbestimmte Schaltspannung abweicht.

Der Schritt 206 des Parallelschaltens des hinzuzuschaltenden TES 102 mit der parallelgeschalteten Teilmenge 112 wird auch als Hinzuschalten bezeichnet. Indem die Kontakte des Schaltschützes 108 beim Hinzuschalten 206 höchstens die vorbestimmte Schaltspannung schalten, werden die Schaltschütze 108 vor einem vorzeitigen Verschleiß geschützt.

Der Systemstrom 128 kann eine Stellgröße des Steuerns im Schritt 204 sein. Die Differenz U_{Sys}-OCV_{Zusch} zwischen der Systemspannung 124 und der Leerlaufspannung des hinzuzuschaltenden TES kann eine Führungsgröße des Steuerns im Schritt 204 sein. Die Systemspannung 124 kann eine zu steuernde Größe des Steuerns im Schritt 204 sein.

Alternativ oder ergänzend kann der Schritt 204 des Steuerns rückgekoppelt sein, d. h. ein Regeln umfassen. Der Systemstrom 128 kann eine Stellgröße des Regelns im Schritt 204 sein. Die Systemspannung 124 kann eine Regelgröße des Schritts 204 sein. Die Leerlaufspannung, OCV_{Zusch}, des hinzuzuschaltenden TES kann eine Zielgröße (auch Sollwert oder Führungsgröße) im Schritt 204 für ein möglichst stromloses Hinzuschalten sein. Die Leerlaufspannung des hinzuzuschaltenden TES kann auch als "Ziel-PickUp"-Spannung, U_{ZP}, bezeichnet werden.

Das Verfahren 200 nutzt den Spannungsabfall über den Innenwiderstand 116 des verbundenen Teilverbunds 112. Dieser Spannungsabfall ist beispielsweise proportional zur Strombelastung 128 dieses Teilverbunds 112, und verschiebt dessen Systemspannung 124 gegenüber seiner Leerlaufspannung 114. Ziel ist es, den Schaltstrom der Schaltschütze 108 im Moment des Hinzuschaltens 206 zu minimieren, welcher sich durch die Differenz zwischen der Leerlaufspannung des abgewichenen und hinzuzuschaltenden TES 102 (oder eines zu verbindenden Energiespeicherverbunds mehrere hinzuzuschaltender TES 102) und der Systemspannung 124 der verbundenen Teilmenge 112 im TES-System 100 ergibt.

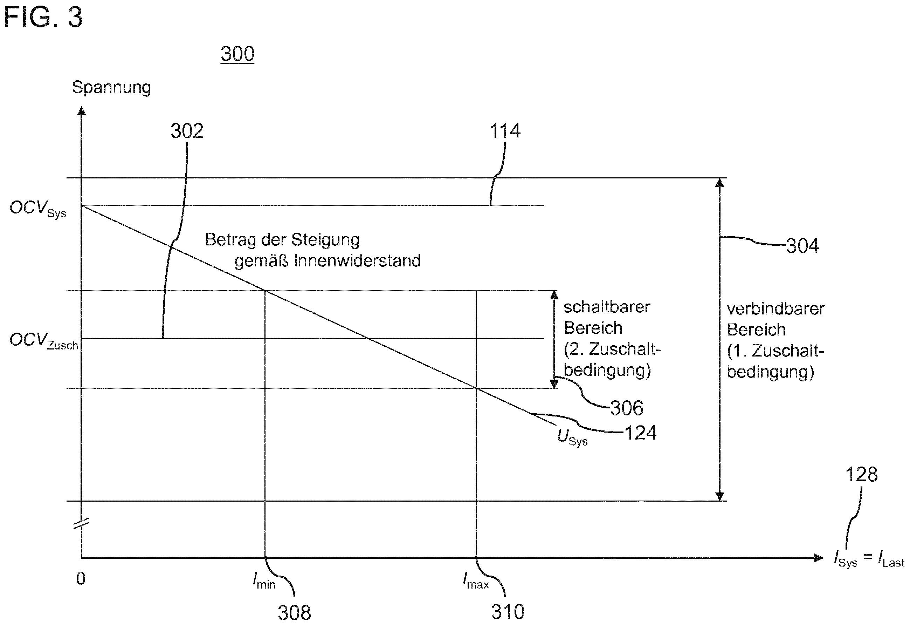

Figur 3 zeigt schematisch eine funktionale Abhängigkeit 300 der Systemspannung 124 vom gesteuerten Systemstrom 128 im Fall einer Stromentnahme (beispielsweise zum Erzeugen eines Antriebsmoments in einem Fahrbetriebsmodus des Fahrzeugs). Die Leerlaufspannung OCV_{Zusch} des hinzuzuschaltenden TES 102 ist beim Bezugszeichen 302 gezeigt.

Eine erster Zuschaltbedingung 304 erfordert, dass die Leerlaufspannungen 114 der parallelgeschalteten Teilmenge 112 und die Leerlaufspannung 302 des hinzuzuschaltenden TES 102 um weniger als eine vorbestimmte Leerlaufspannungsdifferenz voneinander abweichen. Die vorbestimmte Leerlaufspannungsdifferenz verhindert, dass Ausgleichsströme in den nach dem Schritt 206 zusammengeschalteten TES 102 diese beschädigen und/oder den nutzbaren maximalen Systemstrom zu sehr einschränken.

Eine zweite Zuschaltbedingung 306 erfordert, dass die Differenz |U_{Sys}-OCV_{Zusch}| zwischen der Systemspannung 124 und der Leerlaufspannung 302 kleiner als die vorbestimmte Schaltspannung ist. Dies kann im Schritt 204 (durch Steuern oder Regeln) erreicht werden, indem der Systemstrom 128 als die Stellgröße des Schritts 204 größer als eine untere Stromgrenze 308 und kleiner als eine obere Stromgrenze 310 ist. Die Stromgrenzen 308 und 310 können gemäß der funktionalen Abhängigkeit 300 der Systemspannung 124 bestimmt werden aus der Leerlaufspannung 302 des hinzuzuschaltenden TES 102, Leerlaufspannungen 114 der parallelgeschalteten Teilmenge 112 und dem Systeminnenwiderstand 116 der parallelgeschalteten Teilmenge 112.

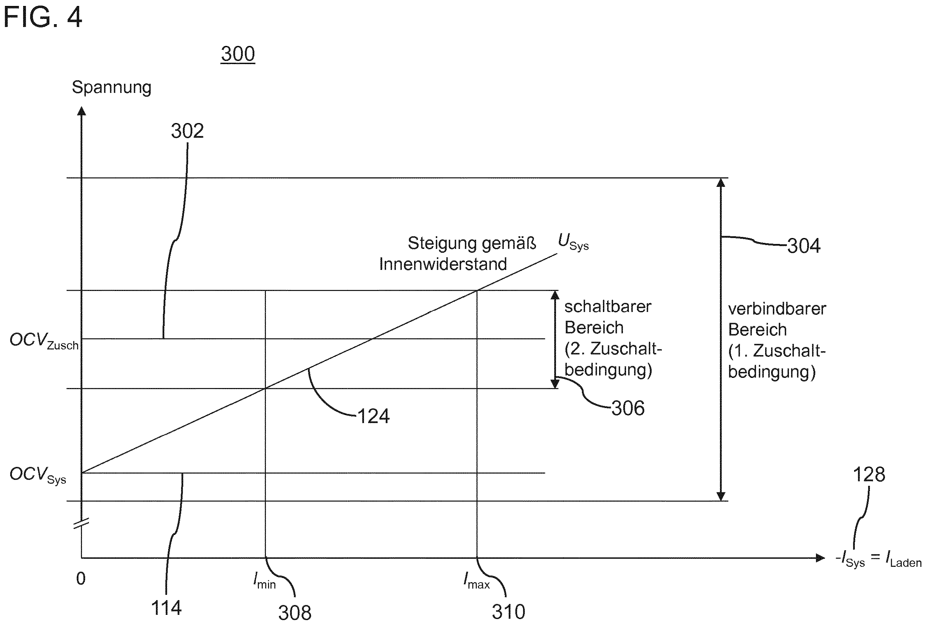

Figur 4 zeigt schematisch eine funktionale Abhängigkeit 300 der Systemspannung 124 vom gesteuerten Systemstrom 128 im Fall einer Stromzufuhr zum TES-System 100, beispielsweise zum Laden des TES-Systems 100 in einem Ladebetriebsmodus des Fahrzeugs. Bei der Rekuperation eines Ladestroms aus Bewegungsenergie mittels einer Rekuperationsbremse gilt eine entsprechende Abhängigkeit 300 im Fahrbetriebsmodus des Fahrzeugs.

Die von der ersten Bedingung 304 zugestandene Spannungsdifferenz (d. h. die vorbestimmte Leerlaufspannungsdifferenz) ist größer als die von der zweiten Bedingung 306 geforderte Spannungsdifferenz (d. h. die vorbestimmte Schaltspannung). Da die zweite Bedingung 306 durch die Steuerung des Systemstroms 128 im Schritt 206 grundsätzlich erfüllbar ist, kommt nur noch die schwächere erste Bedingung 304 zum Tragen. Dadurch kann die Häufigkeit der Zuschaltmöglichkeiten erhöht werden, beispielsweise ohne zusätzlichen Verschleiß der Schaltschütze 108.

Die erste Zuschaltbedingung 304 kann durch die Energieentnahme oder die Energiezufuhr am TES-System 100 erfüllt werden. Beispielsweise können die genutzten TES 102 (d. h. die TES 102 der Teilmenge 112) für eine zumindest im Zeitmittel überwiegende Energieentnahme die TES 102 mit den größten Leerlaufspannungen aller TES 102 im TES-System 100 umfassen. Für eine zumindest im Zeitmittel überwiegende Energiezufuhr kann die Teilmenge 112 die TES 102 mit den kleinsten Leerlaufspannungen aller TES 102 im TES-System 100 umfassen. Dadurch konvergieren die Leerlaufspannungen 104 der TES 102 des TES-Systems 100 im Lauf der Nutzung des TES-Systems 100. Beispielsweise kann so die erste Zuschaltbedingung 304 erfüllt werden in Koinzidenz mit einem Bedarf für das Hinzuschalten weiterer Speicherkapazität im TES-System 100.

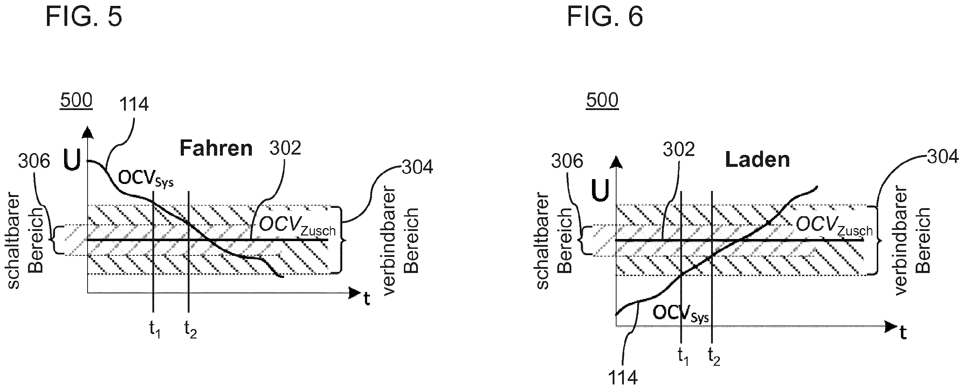

Figur 5 zeigt schematisch einen zeitlichen Verlauf 500 der Leerlaufspannung 114 des TES-Systems 100 bei überwiegender Energieentnahme. Figur 6 zeigt schematisch einen zeitlichen Verlauf 500 der Leerlaufspannung 114 des TES-Systems 100 bei überwiegender Energiezufuhr.

Während herkömmlicherweise ein Hinzuschalten erst bei Erfüllung der zweiten Zuschaltbedingung 306 zum Zeitpunkt t₂ ermöglicht ist, ist durch das Verfahren 200 ein Hinzuschalten 206 bei entsprechender Stromsteuerung 204 bereits ab dem Zeitpunkt t₁ ermöglich. Zudem muss zum Zeitpunkt des Hinzuschaltens 206 der Stromfluss (in oder aus dem TES-System 100) nicht notwendigerweise unterbrochen oder nahezu auf null reduziert werden.

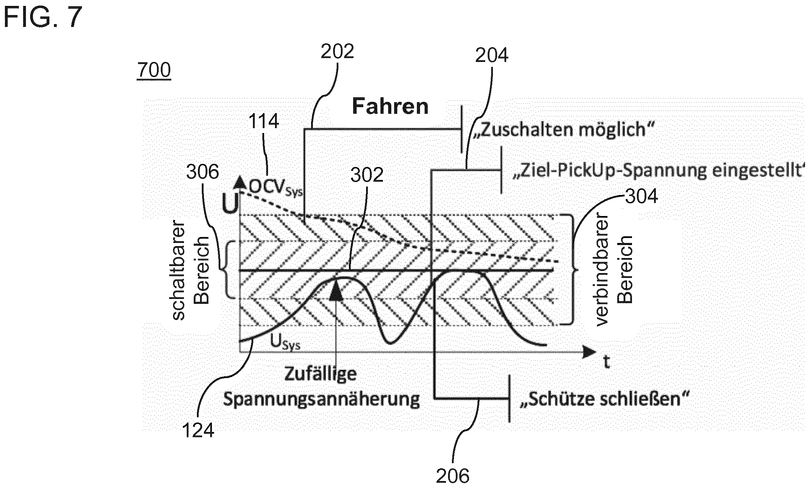

Figur 7 zeigt schematisch einen zeitlichen Verlauf 700 der Leerlaufspannung 114 und der Spannung 124 des TES-Systems 100 bei überwiegender Energieentnahme. Beispielsweise wird im Schritt 202 die Erfüllung der ersten Zuschaltbedingung 304 festgestellt (entsprechend dem Zeitpunkt t₁ in der Figuren 5).

Optional wird eine zufällige Annäherung der Spannung 124 des TES-Systems 100 und der Leerlaufspannung 302 des hinzuzuschaltenden TES 102, welche die zweite Zuschaltbedingung 306 erfüllen würde, nicht zum Hinzuschalten 206 genutzt, da die Zeitdauer, in der die zweite Zuschaltbedingung 306 zufällig erfüllt bleibt, unkontrolliert ist.

Durch die Stromsteuerung 204 kann eine bessere Annäherung der Spannung 124 des TES-Systems 100 und der Leerlaufspannung 302 des hinzuzuschaltenden TES 102 und/oder eine definierte Zeitdauer für die Erfüllung der zweiten Zuschaltbedingung 306 erreicht werden. Dadurch kann die zweite Zuschaltbedingung 306 während des gesamten Vorgangs des Hinzuschaltens 206 erfüllt bleiben.

Ausführungsbeispiele ermöglichen ein Hinzuschalten von in der Leerlaufspannung 104 weit auseinandergelaufenen TES 102 zum Verbund 112. Der Laststrom oder der Ladestrom wird in das Steuern 204 des Hinzuschaltens 206 einbezogen, wodurch einerseits der Zeitrahmen, in dem das Hinzuschalten 206 ausgeführt werden kann, erweitert wird und andererseits eine Leistungseinschränkung (durch das herkömmliche Verringern oder Unterbrechen des Systemstroms während des Schaltvorgangs) deutlich vermindert wird.

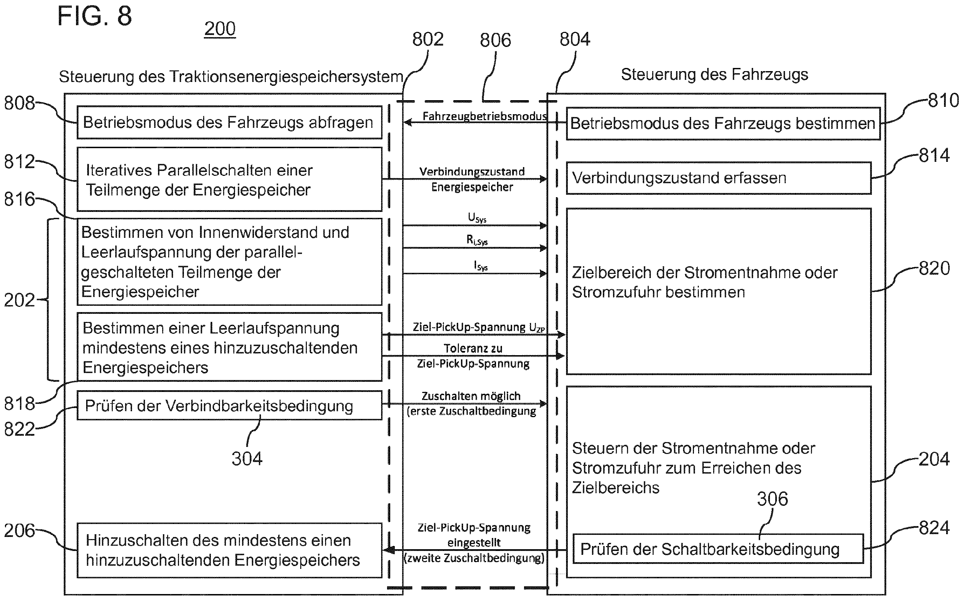

Figur 8 zeigt eine beispielhafte erste Implementierung des Verfahrens 200. Die Ausführung des Verfahrens 200 ist zwischen einer Steuerung 802 des TES-Systems 100 und einer Steuerung 804 des Fahrzeugs aufgeteilt. Hierzu stehen die Steuerung 802 und die Steuerung 804 in Signalaustausch gemäß einer Signalschnittstelle 806.

Die in Figur 8 gezeigte Implementierung geht von einem Zustand aus, in dem sämtliche TES 102 des TES-Systems 100 vom Gleichspannungszwischenkreis entkoppelt sind, beispielsweise durch die zweite Stellung aller Schaltschütze 108.

In Schritten 808 und 810 wird der aktuelle Betriebsmodus des Fahrzeugs ermittelt. Der Betriebsmodus soll "Laden" sein, falls zumindest eine Teilmenge 112 der TES 102 (oder nach einfacher oder mehrfacher Anwendung des Verfahrens 200 alle TES 102 des TES-Systems 100) im folgenden Verlauf an einer Ladeinfrastruktur geladen werden soll. Der Betriebsmodus soll "Fahren" sein, falls zumindest eine Teilmenge 112 der TES 102 (oder alle TES 102) im folgenden Verlauf zum Betrieb des Fahrzeugs verwendet werden soll.

In einem Zuschaltprozess 812 wird die parallelgeschaltete Teilmenge 112 der TES 102 im TES-System 100 aufgebaut. Dazu werden, beispielsweise durch Messung der Klemmenspannungen, die aktuellen Leerlaufspannungen 104 aller noch unverbundenen TES 102 ermittelt. Alle TES 102, welche die (auf die Differenz der Leerlaufspannungen angewandte) zweite Bedingung 306 erfüllen, werden iterativ in der Reihenfolge der Absolutgrößen ihrer Leerlaufspannungen 104 mit dem Gleichspannungszwischenkreis verbunden durch Schließen der jeweiligen Schaltschütze 108 in der zweiten Stellung.

Der erste zu verbindende Energiespeicher wird abhängig vom Fahrzeugbetriebsmodus ermittelt. Im Fahrzeugbetriebsmodus "Fahren" wird das iterative Zuschalten mit demjenigen TES 102 mit der höchsten Leerlaufspannung 104 begonnen. Im Fahrzeugbetriebsmodus "Laden" beginnt der Aufbau des Verbunds 112 mit demjenigen TES 102 mit der niedrigsten Leerlaufspannung 104.

Falls im iterativen Zuschaltprozess 812 ein TES 102 aufgrund einer die zweite Bedingung 306 nicht erfüllenden Abweichung seiner Leerlaufspannung 104 zu der bereits parallelgeschalteten Teilmenge 112 nicht zugeschalten werden kann oder soll, wird der iterative Zuschaltprozess 812 abgebrochen.

Die parallelgeschaltete Teilmenge 112 der bis zu diesem Zeitpunkt verbundenen TES 102 bilden den aktuell für das Fahrzeug nutzbaren Teil des TES-Systems 100. Die Teilmenge 112 besteht aus mindestens einem TES 102. Der Verbindungszustand des TES-Systems 100, insbesondere die Anzahl oder der Anteil der TES 102 in der Teilmenge 112, wird im Schritt 814 an das Fahrzeug übermittelt.

Die Leerlaufspannungen 104 der übrigen TES 102 werden analysiert, beispielsweise mittels Clusteranalyse. TES 102, deren relative Lage der Leerlaufspannung 104 eine Zuschaltung untereinander prinzipiell zulässt (beispielsweise gemäß der auf die Differenz der Leerlaufspannungen 104 angewandten zweiten Bedingung 306), werden im Folgenden als ein hinzuzuschaltender TES-Verbund betrachtet.

Der hinzuzuschaltende TES 102 oder die den hinzuzuschaltenden TES-Verbund bildenden TES 102 werden gemäß dem Verfahren 200 mit dem nutzbaren TES-System 100, d. h. der Teilmenge 112, verbunden. Im Fall mehrerer jeweils hinzuzuschaltender TES 102 oder mehrere jeweils hinzuzuschaltender TES-Verbünde wird das Verfahren 200 sequentiell mit dem aktuell nutzbaren TES-System 100, d. h. der jeweils parallelgeschalteten Teilmenge 112, verbunden. Mit dem aus dem Verfahren 200 resultierenden TES-System 100 kann dann der Fahrzeugbetrieb dargestellt werden.

Im Schritt 816, beispielsweise als Teilschritt des Schritts 202, wird kontinuierlich die Systemleerlaufspannung 114 des im Betrieb belasteten TES-Systems 100, OCV_{Sys}, ermittelt, z. B. durch Abschätzung des Systeminnenwiderstands 116 und Messung der Systemspannung 124 und des Systemstroms 128. Ferner wird im Schritt 818, beispielsweise als Teilschritt des Schritts 202, die Leerlaufspannung 302 des als nächstes hinzuzuschaltenden mindestens einen TES 102 bestimmt (einzelner TES 102 oder TES-Verbund, z. B. durch Messung der Klemmenspannung eines TES 102 des unbelasteten TES-Verbunds).

Im Schritt 820, beispielsweise als Teilschritt des Schritts 202, wird auf Grundlage der Systemleerlaufspannung 114, des Systeminnenwiderstands 116, der Systemspannung 124 und des Systemstroms 128 ein Zielbereich (beispielsweise die Stromgrenzen 308 und 310) für den im Schritt 204 gesteuerten Systemstrom 128 berechnet.

Im Schritt 822 wird die Systemleerlaufspannung 114, OCV_{Sys}, und die Leerlaufspannung 104 des hinzuzuschaltenden mindestens einen TES 102, OCV_{Zusch}, verglichen. Falls deren Differenz kleiner einer als die vorbestimmte Leerlaufspannungsdifferenz ist, ist die ersten Zuschaltbedingung 304 erfüllt.

Die vorbestimmte Leerlaufspannungsdifferenz der ersten Zuschaltbedingung 304 kann eine berechnete Schwelle sein. Die Leerlaufspannungsdifferenz berechnet sich derart, dass die Ausgleichströme zwischen den TES 102, welche sich ergeben würden aufgrund der unterschiedlichen Lagen der Leerlaufspannungen 104 der TES 102 in einem Verbund nach dem Schritt 206 des Hinzuschaltens, hinreichend gering sind. Kriterien für einen maximalen Ausgleichsstrom (und damit die berechnete Schwelle) folgen beispielsweise aus dem Komponentenschutz, einer Verlustleistungsbetrachtung an den Innenwiderständen 106 und/oder einer maximal tolerierbaren Einschränkung der Stromgrenzen für den Systemstrom 128. Solange sich die Systemleerlaufspannung 114, OCV_{Sys}, innerhalb der berechneten Grenzen befindet, wird im Schritt 822 die erste Zuschaltbedingung 304 als erfüllt angesehen.

Im mit der Erfüllung der ersten Zuschaltbedingung 304 ausgelösten Schritt 204 des Steuerns wird das aktuell nutzbare TES-System 100 gezielt belastet. Der Systemstrom 128 wird so gesteuert, dass die Differenz zwischen der aus der Stromabhängigkeit 300 resultierenden Systemspannung 124, U_{Sys}, und der Leerlaufspannung 104, OCV_{Zusch}, des hinzuzuschaltenden mindestens einen TES 102 kleiner als eine vorbestimmte Schaltspannung der zweiten Zuschaltbedingung 306 ist. Die Schaltspannung der zweiten Zuschaltbedingung 306 ist so bestimmt, dass der durch diese Spannungsdifferenz über die Schaltschütze 108 getriebene Strom während des Schritts 206 des Hinzuschaltens kleiner als ein maximaler Schaltstrom der Schaltschütze 108 ist.

Wird das TES-System 100 so belastet, dass die Spannungen U_{Sys} und OCV_{Zusch} gleich sind, fließt während des Hinzuschaltens 206 kein Strom über die Schaltschütze 108 des hinzuzuschaltenden mindestens einen TES 102. Die Leerlaufspannung OCV_{Zusch} stellt damit die Zielspannung für die Systemspannung 124 dar und wird deshalb im Folgenden als Ziel-PickUp-Spannung, U_{ZP}, bezeichnet. Um die Ziel-PickUp-Spannung U_{ZP} wird ein Toleranzband für die zweite Zuschaltbedingung 306 bestimmt. Das Toleranzband wird so berechnet, dass jede Systemspannung 124 innerhalb des Toleranzbands einen hinreichend geringen Schaltstrom beim Hinzuschalten 206 ergibt. Kriterien für die Wahl des Toleranzbands der zweiten Zuschaltbedingung 306 folgen beispielsweise aus dem maximalen Schaltstrom oder Schaltströmen der Schaltschütze 108.

Mithilfe der Innenwiderstände 106 der TES 102 lässt sich ein minimaler Systemstrom 308 und ein maximaler Systemstrom 310 für den Systemstrom 128 berechnen, der die Systemspannung 124 innerhalb des Toleranzbands der zweiten Zuschaltbedingung 306 bringt und hält.

Das Erfüllen der zweiten Zuschaltbedingung 306 wird im Schritt 824 geprüft. Das Erfüllen der zweiten Zuschaltbedingung 306 löst den Schritt 206 des Hinzuschaltens aus. Dadurch ist die Teilmenge 112 um das mindestens eine hinzuzuschaltende TES 102 erweitert.

Falls noch weitere TES 102 zum Hinzuschalten vorliegen, wird ausgehend von der erweiterten Teilmenge 112 durch entsprechendes Steuern 204 die nächste Lage der Leerlaufspannung 104 gemäß dem Verfahren 200 angesteuert.

Das Steuern 204 des Systemstroms 128 kann eine oder mehrere fahrzeugseitig umgesetzte Maßnahmen umfassen. Beispielsweise werden im Schritt 204 verschiedene fahrzeugseitige Maßnahmen dahingehend überprüft, ob dadurch ein die zweite Zuschaltbedingung 306 erfüllender Systemlaststrom 128 einstellbar ist.

Die Maßnahmen müssen im Schritt 204 so umsetzbar sein, dass der Systemlaststrom 128 für einen Mindestzeitraum in den berechneten Grenzen 308 und 310 gehalten werden kann, ohne beispielsweise ein selbstbeschleunigendes Fahrverhalten zu verursachen. Der Mindestzeitraum wird beispielsweise aus einer Schließdauer der Schaltschütze 108 und Signallaufzeiten (z. B. 200 ms) für die Kommunikation zwischen einer elektronischen Steuereinheit (ECU) 802 des TES-Systems 100 und einer ECU 804 des Fahrzeugs bestimmt. Je nach Fahrzeugbetriebsmodus kann der Schritt 204 unterschiedliche Maßnahmen umfassen.

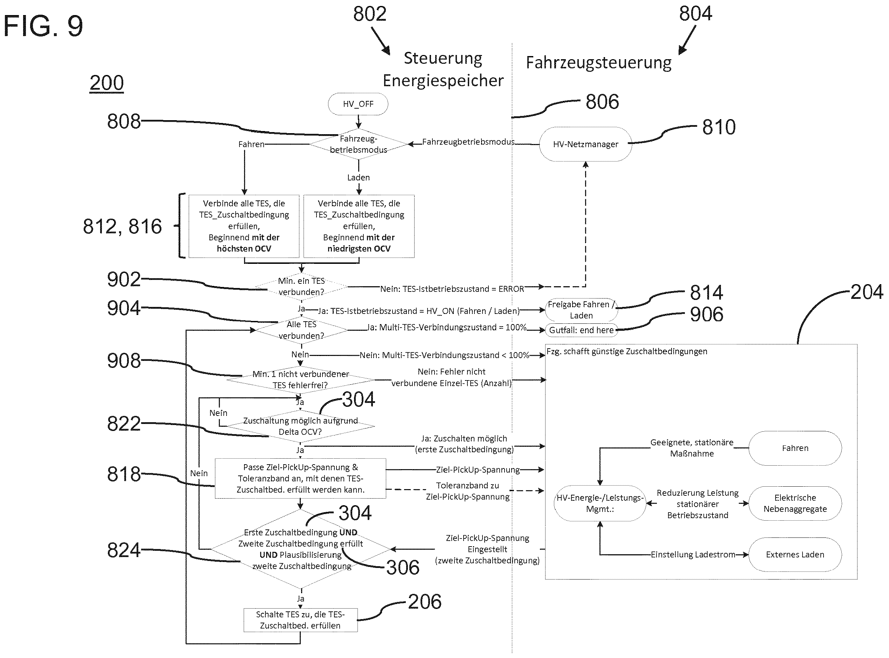

Figur 9 zeigt ein Flussdiagramm einer beispielhaften zweiten Implementierung des Verfahrens 200. Die Ausführung des Verfahrens 200 ist zwischen der Steuerung 802 des Traktionsenergiespeichersystems und der Steuerung 804 des Fahrzeugs aufgeteilt. Hierzu stehen die Steuerung 802 und die Steuerung 804 in Signalaustausch gemäß der Signalschnittstelle 806.

Mit der Figur 8 übereinstimmende Bezugszeichen betreffen entsprechende Verfahrensschritte der ersten Implementierung. Die zweite Implementierung ist gegenüber der ersten Implementierung um optionale Signalschnittstellen zur Fehlerbehandlung ergänzt.

In einem Schritt 902 überprüft, dass die Teilmenge 112 mindestens ein TES 102 umfasst. In einem Schritt 904 wird der Fall abgefragt, dass bereits alle TES 102 des TES-Systems 100 im Schritt 812 parallelgeschaltet wurden. In diesem Fall endet das Verfahren am Punkt 906. Im Schritt 908 wird sichergestellt, dass die Teilmenge 112 mindestens ein fehlerfreies TES 102 umfasst.

Im Schritt 824 wird kontinuierlich überprüft, ob sowohl die erste Zuschaltbedingung 304 als auch die zweite Zuschaltbedingung 306 erfüllt sind. Ist dies der Fall wird ferner eine Plausibilitätskontrolle durchgeführt, ob die umgesetzte Maßnahme ausreichend ist, beispielsweise ob die gemessene Systemspannung 124 tatsächlich in dem durch das Toleranzband der zweiten Zuschaltbedingung 306 bestimmten Bereich ist. Ist dies der Fall, wird die Freigabe zum Hinzuschalten 206 des zu verbindenden TES 102 oder TES-Verbunds signalisiert und die entsprechenden Schaltschütze 108 geschlossen.

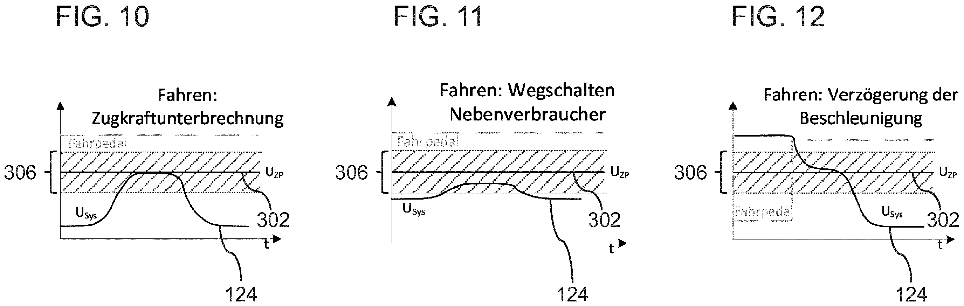

Die Figuren 10 bis 12 zeigen beispielhafte zeitliche Verläufe von Systemgrößen bei der Umsetzung von durch den Schritt 204 gesteuerter fahrzeugseitiger Maßnahmen. Beispielsweise kann im Schritt 204 eine oder mehrere der folgenden Maßnahmen ausgeführt werden.

Im Fahrzeugbetriebsmodus "Fahren" kann eine Zugkraft reduziert oder unterbrochen werden (Zugkraftunterbrechung). Durch vollständige oder teilweise Rücknahme des Fahrantriebsmoments wird das TES-System 100 soweit entlastet, dass die Systemspannung 124 innerhalb der Grenzen der zweiten Zuschaltbedingung 306 liegt. Ein schematischer Verlauf der Systemspannung 124 ist in Fig. 10 gezeigt.

Alternativ oder ergänzend werden im Fahrzeugbetriebsmodus "Fahren" ein oder mehrere elektrische Nebenverbraucher (z. B. eine Klimatisierung) abgeschaltet. Durch ein kurzzeitige Abschaltung oder eine Leistungsreduzierung elektrischer Nebenverbraucher wird das TES-System 100 soweit entlastet, dass die Systemspannung 124 innerhalb der Grenzen der zweiten Zuschaltbedingung 306 gehalten wird. Ein schematischer Verlauf der Systemspannung 124 ist in Fig. 11 gezeigt.

Alternativ oder ergänzend wird im Fahrzeugbetriebsmodus "Fahren" eine Beschleunigung zeitlich verzögert und/oder abgestuft umgesetzt. Ein schematischer Verlauf der Systemspannung 124 und einer Änderung einer Fahrpedalstellung ist in Fig. 12 gezeigt. Der durch eine erhöhte Drehmomentanforderung (gemäß der Fahrpedalstellung) erzeugte Durchgang der Systemspannung 124 durch das Toleranzband der zweiten Zuschaltbedingung 306 wird innerhalb des Toleranzbandes verzögert, beispielsweise beim Erreichen der Zielspannung 302. Hierbei kann der Drehmomentaufbau, aus welchem ein zunehmender Systemlaststrom 128 resultiert, kurzzeitig verzögert werden.

Alternativ oder ergänzend wird im Fahrzeugbetriebsmodus "Fahren" eine Fahrpedalrücknahme verzögert. Der durch eine erniedrigte Drehmomentanforderung erzeugte Durchgang der Systemspannung durch das Toleranzband wird innerhalb des Toleranzbandes verzögert. Hierbei kann der Drehmomentabbau, aus welchem ein abnehmender Systemlaststrom 128 resultiert, kurzzeitig verzögert werden. Diese Maßnahme wird vorzugsweise nur umgesetzt, falls nach der Rücknahme der Drehmomentanforderung das Antriebsmoment nicht länger als eine (beispielsweise durch den bei einem typischen Gradienten der Drehmomentrücknahme) erwartete Zeitspanne bestehen bleibt.

Alternativ oder ergänzend wird im Fahrzeugbetriebsmodus "Fahren" die Dauerbremsanforderung zurückgenommen. Durch vollständige oder teilweise Rücknahme eines elektrischen Dauerbremsmoments (beispielsweise mittels der Rekuperationsbremse) wird das TES-System 100 soweit entlastet, dass die Systemspannung 124 innerhalb der Grenzen der zweiten Zuschaltbedingung 306 gehalten wird. Optional wird der Wegfall des Dauerbremsmoments durch ein wirkungsgleiches Ansteuern einer mechanischen Dauerbremse und/oder einer Verschleißbremsen kompensiert.

Ferner kann im Fahrzeugbetriebsmodus "Laden" ein gewünschter Ladestroms eingestellt werden. Beispielsweise wird der Ladestrom 128 kurzeitig innerhalb der Stromgrenzen 308 und 310 gesteuert. Hierbei kann das Fahrzeug über eine Kommunikationsschnittstelle zur Ladeinfrastruktur den gewünschten Ladestrom 128 vorgeben.

Die verschiedenen Maßnahmen werden verglichen und hinsichtlich verschiedener Kriterien (beispielsweise Komfort und/oder Komponentenschutz) bewertet. Eine gemäß der Bewertung optimale Maßnahmen oder Maßnahmenkombination wird im Schritt 204 umgesetzt. Wird während der Umsetzung die Ziel-PickUp-Spannung 302 hinreichend nahe erreicht (mindestens innerhalb des Toleranzbands), wird die zweite Zuschaltbedingung 306 als erfüllt angesehen.

Wie die vorstehende Beschreibung verdeutlicht können Ausführungsbeispiele eine Einschränkung der elektrischen Leistung eines Teilverbunds von Energiespeichern im Rahmen des Zuschaltvorgangs deutlich verringert oder vermieden.

Nämliche oder weitere Ausführungsbeispiele können flexiblere Zu- und/oder Abschaltungen von Energiespeichern oder Energiespeicher-Verbünden während des Betriebs ermöglichen, beispielsweise ohne Herunterfahren oder Trennen aller Verbraucher und Einspeiser an einem Hochvolt-Kreis.

Der Zeitraum für eine mögliche Verbindung eines abgewichenen Energiespeichers kann deutlich erweitert werden. Alternativ oder zusätzlich kann der Zeitpunkt des Zuschaltvorgangs kontrollierbar sein. Ferner kann die Stromsteuerung durch Maßnahmen fahrzeugseitig so umgesetzt werden beim Zuschaltvorgang, dass eine für Nutzer (beispielsweise den Fahrer oder Insassen) wahrnehmbare Beeinträchtigung des Fahrzeugbetriebs minimiert wird.

Der Schaltstrom der Schaltschütze kann verringert oder begrenzt werden. Damit kann die Lebensdauer der Schaltschütze verlängert werden.

Das Verfahren kann ferner für eine kontrollierte Abschaltung eines Energiespeichers oder eines Energiespeicher-Verbunds eingesetzt werden.

Obwohl die Erfindung in Bezug auf exemplarische Ausführungsbeispiel beschrieben worden ist, ist es für einen Fachmann ersichtlich, dass verschiedene Änderungen vorgenommen werden können und Äquivalente als Ersatz verwendet werden können. Ferner können viele Modifikationen vorgenommen werden, um eine bestimmte Situation oder ein bestimmtes Material an die Lehre der Erfindung anzupassen. Folglich ist die Erfindung nicht auf die offenbarten Ausführungsbeispiele beschränkt, sondern umfasst alle Ausführungsbeispiele, die in den Bereich der beigefügten Patentansprüche fallen.

### Bezugszeichenliste

- 100: Traktionsenergiespeichersystem
- 102: Energiespeicher des Traktionsenergiespeichersystems
- 104: Leerlaufspannung eines Energiespeichers
- 106: Innenwiderstand eines Energiespeichers
- 108: Schaltschütz eines Energiespeichers
- 112: Parallelgeschaltete Teilmenge und Verbund der Energiespeicher
- 114: Leerlaufspannung des Traktionsenergiespeichersystems
- 116: Innenwiderstand des Traktionsenergiespeichersystems
- 122: Leistungsschnittstelle des Traktionsenergiespeichersystems
- 124: Spannung des Traktionsenergiespeichersystems
- 126: Lastwiderstand an der Leistungsschnittstelle
- 128: Strom des Traktionsenergiespeichersystems
- 200: Verfahren zum Betrieb eines Traktionsenergiespeichersystem
- 202: Schritt des Bestimmens
- 204: Schritt des Steuerns
- 206: Schritt des Parallelschaltens
- 300: Funktionale Abhängigkeit
- 302: Leerlaufspannung des hinzuzuschaltenden Energiespeichers
- 304: Erste Zuschaltbedingung
- 306: Zweite Zuschaltbedingung
- 308: Minimaler Systemstrom
- 310: Maximaler Systemstrom
- 500: Verlauf der Leerlaufspannung des Traktionsenergiespeichersystems
- 700: Verlauf der Spannung des Traktionsenergiespeichersystems
- 802: Steuerung des Traktionsenergiespeichersystems
- 804: Steuerung des Fahrzeugs
- 806: Signalschnittstelle
- 808: Schritt des Abfragens eines Betriebsmodus
- 810: Schritt des Bestimmens eines Betriebsmodus
- 812: Schritt des Ausführens eines Zuschaltprozesses
- 814: Schritt des Angebens eines Verbindungszustands
- 816: Schritt des Bestimmens des Systeminnenwiderstands
- 818: Schritt des Bestimmens der Leerlaufspannung eines Energiespeichers
- 820: Schritt des Bestimmens eines Zielbereichs des Systemstroms
- 822: Schritt des Überprüfens der ersten Zuschaltbedingung
- 824: Schritt des Überprüfens der zweiten Zuschaltbedingung
- 902: Schritt des Überprüfens einer leeren Teilmenge
- 904: Schritt des Überprüfens einer vollständigen Teilmenge
- 906: Vorzeitiges Verfahrensende
- 908: Schritt des Überprüfens einer funktionsfähigen Teilmenge

## Patentansprüche

1. Verfahren (200) zum Betrieb eines Traktionsenergiespeichersystems (100) eines Fahrzeugs mit mehreren parallelschaltbaren Energiespeichern (102), bei dem eine Teilmenge (112) der Energiespeicher parallelgeschaltet ist und mindestens ein hinzuzuschaltender Energiespeicher nicht mit der parallelgeschalteten Teilmenge parallelgeschaltet ist, umfassend:
Bestimmen (202) eines Innenwiderstands (116) der parallelgeschalteten Teilmenge (112) der Energiespeicher, einer Leerlaufspannung (114) der parallelgeschalteten Teilmenge (112) der Energiespeicher und einer Leerlaufspannung (302) des mindestens einen hinzuzuschaltenden Energiespeichers;
Steuern (204) eines Stroms (128) durch die parallelgeschaltete Teilmenge (112) der Energiespeicher, der so bemessen ist, dass die Leerlaufspannung (114) der parallelgeschalteten Teilmenge (112) der Energiespeicher und ein durch den Strom (128) und den Innenwiderstand (116) bewirkter Spannungsabfall eine Spannung (124) der parallelgeschalteten Teilmenge (112) der Energiespeicher ergeben, die von der Leerlaufspannung (302) des mindestens einen hinzuzuschaltenden Energiespeichers um weniger als eine vorbestimmte Schaltspannung abweicht;
Parallelschalten (206) des mindestens einen hinzuzuschaltenden Energiespeichers mit der parallelgeschalteten Teilmenge (112) der Energiespeicher während die Spannung (124) der parallelgeschalteten Teilmenge (112) der Energiespeicher von der Leerlaufspannung (302) des mindestens einen hinzuzuschaltenden Energiespeichers um weniger als die vorbestimmte Schaltspannung abweicht; und
Bestimmen eines Betriebsmodus des Fahrzeugs, wobei bei einem vom Traktionsenergiespeichersystem (100) hauptsächlich Energie entnehmenden Betriebsmodus die Leerlaufspannung (114) der parallelgeschalteten Teilmenge (112) größer als die Leerlaufspannung (302) des mindestens einen hinzuzuschaltenden Energiespeichers ist, und/oder bei einem dem Traktionsenergiespeichersystem (100) hauptsächlich Energie zuführenden Betriebsmodus die Leerlaufspannung (114) der parallelgeschalteten Teilmenge (112) kleiner als die Leerlaufspannung (302) des mindestens einen hinzuzuschaltenden Energiespeichers ist,
**dadurch gekennzeichnet, dass**
der Strom (128) gesteuert wird, indem eine aufgenommene und/oder abgegebene elektrische Leistung eines mit der parallelgeschalteten Teilmenge (112) der Energiespeicher verbundenen Nebenverbrauchers verändert wird.

2. Verfahren nach Anspruch 1, wobei die Spannung (124) der parallelgeschalteten Teilmenge (112) der Energiespeicher an einer Leistungsschnittstelle (122) des Traktionsenergiespeichersystems (100) anliegt.

3. Verfahren nach Anspruch 2, wobei der gesteuerte Strom (128) durch die Leistungsschnittstelle (122) des Traktionsenergiespeichersystems (100) fließt.

4. Verfahren nach Anspruch 2 oder 3, wobei der gesteuerte Strom (128) durch die Leistungsschnittstelle (122) des Traktionsenergiespeichersystems (100) vor, während und nach dem Parallelschalten (206) von Null verschieden ist.

5. Verfahren nach einem der Ansprüche 1 bis 4, wobei die Ausführung zumindest der Schritte des Steuerns (204) und Parallelschaltens (206) voraussetzt, dass die Leerlaufspannung (114) der parallelgeschalteten Teilmenge (112) von der Leerlaufspannung (302) des mindestens einen hinzuzuschaltenden Energiespeichers um weniger als eine vorbestimmte Leerlaufspannungsdifferenz abweicht, wobei die vorbestimmte Leerlaufspannungsdifferenz größer ist als die vorbestimmte Schaltspannung.

6. Verfahren nach einem der Ansprüche 1 bis 5, wobei der Schritt des Steuerns (204) die Spannung (124) der parallelgeschalteten Teilmenge (112) der Energiespeicher auf die Leerlaufspannung (302) des mindestens einen hinzuzuschaltenden Energiespeichers regelt.

7. Verfahren nach Anspruch 6, wobei der Schritt des Steuerns (204) die Spannung (124) der parallelgeschalteten Teilmenge (112) regelt während einer Zeitspanne, die den Schritt des Parallelschaltens (206) umfasst.

8. Verfahren nach Anspruch 7, wobei die Zeitspanne größer als 50 ms und/oder kleiner als 500 ms ist.

9. Verfahren nach einem der Ansprüche 1 bis 8, wobei der Strom (128) gesteuert wird, indem ein mittels des Stroms bewirktes Antriebsmoment des Fahrzeugs verändert oder verzögert wird.

10. Verfahren nach Anspruch 9 in Verbindung mit Anspruch 7 oder 8, wobei das bewirkte Antriebsmoment außerhalb der Zeitspanne einer Fahreranforderung entspricht und/oder während der Zeitspanne von einer Fahreranforderung abweicht.

11. Verfahren nach einem der Ansprüche 1 bis 10, wobei der Strom (128) einen Ladestrom umfasst und in Kommunikation mit einer Ladeinfrastruktur gesteuert wird.

12. Verfahren nach einem der Ansprüche 1 bis 11, wobei der Strom (128) einen Rekuperationsstrom einer elektrischen Dauerbremse umfasst und durch Verringerung einer Bremsleistung der Dauerbremse bei zeitgleicher Vergrößerung einer Bremsleistung einer Verschleißbremse gesteuert wird.

13. Traktionsenergiespeichersystem (100) eines Fahrzeugs, umfassend:
mehrere parallelschaltbare Energiespeicher (102); und
mindestens eine mit dem Fahrzeug in Signalaustausch stehende Steuerung (802; 804), die dazu ausgebildet ist, die Schritte eines der Ansprüche 1 bis 12 jeweils auszuführen oder zu steuern.

14. Kraftfahrzeug, insbesondere Nutzfahrzeug, mit einem Traktionsenergiespeichersystem (100) gemäß Anspruch 13.

## Claims

1. A method (200) for operating a traction energy storage system (100) of a vehicle having a plurality of energy stores (102) which are able to be connected in parallel, in which method a subset (112) of the energy stores are connected in parallel and at least one energy store which is to be added is not connected in parallel with the parallel-connected subset, comprising:
determining (202) an internal resistance (116) of the parallel-connected subset (112) of the energy stores, an open-circuit voltage (114) of the parallel-connected subset (112) of the energy stores and an open-circuit voltage (302) of the at least one energy store which is to be added;
controlling (204) a current (128) through the parallel-connected subset (112) of the energy stores, which current is dimensioned such that the open-circuit voltage (114) of the parallel-connected subset (112) of the energy stores and a voltage drop effected by the current (128) and the internal resistance (116) produce a voltage (124) of the parallel-connected subset (112) of the energy stores which differs from the open-circuit voltage (302) of the at least one energy store which is to be added by less than a predetermined switching voltage; connecting (206) the at least one energy store which is to be added in parallel with the parallel-connected subset (112) of the energy stores while the voltage (124) of the parallel-connected subset (112) of the energy stores differs from the open-circuit voltage (302) of the at least one energy store which is to be added by less than the predetermined switching voltage; and determining an operating mode of the vehicle, wherein, in the case of an operating mode which is primarily drawing energy from the traction energy storage system (100), the open-circuit voltage (114) of the parallel-connected subset (112) is greater than the open-circuit voltage (302) of the at least one energy store which is to be added and/or, in the case of an operating mode which is primarily supplying energy to the traction energy storage system (100), the open-circuit voltage (114) of the parallel-connected subset (112) is less than the open-circuit voltage (302) of the at least one energy store which is to be added,
**characterized in that**
the current (128) is controlled by changing an electrical power which is taken up and/or output by an auxiliary load connected to the parallel-connected subset (112) of the energy stores.

2. The method according to Claim 1, wherein the voltage (124) of the parallel-connected subset (112) of the energy stores is applied at a power interface (122) of the traction energy storage system (100).

3. The method according to Claim 2, wherein the controlled current (128) flows through the power interface (122) of the traction energy storage system (100).

4. The method according to Claim 2 or 3, wherein the controlled current (128) through the power interface (122) of the traction energy storage system (100) is different from zero before, during and after the parallel connection (206).

5. The method according to one of Claims 1 to 4, wherein performing at least the steps of control (204) and parallel connection (206) presupposes that the open-circuit voltage (114) of the parallel-connected subset (112) differs from the open-circuit voltage (302) of the at least one energy store which is to be added by less than a predetermined open-circuit voltage difference, wherein the predetermined open-circuit voltage difference is greater than the predetermined switching voltage.

6. The method according to one of Claims 1 to 5, wherein the control step (204) regulates the voltage (124) of the parallel-connected subset (112) of the energy stores to the open-circuit voltage (302) of the at least one energy store which is to be added.

7. The method according to Claim 6, wherein the control step (204) regulates the voltage (124) of the parallel-connected subset (112) during a period of time which comprises the step of parallel connection (206) .

8. The method according to Claim 7, wherein the period of time is greater than 50 ms and/or less than 500 ms.

9. The method according to one of Claims 1 to 8, wherein the current (128) is controlled by changing or delaying a drive torque of the vehicle which is effected by means of the current.

10. The method according to Claim 9 in connection with Claim 7 or 8, wherein the effected drive torque corresponds to a driver request outside of the period of time and/or differs from a driver request during the period of time.

11. The method according to one of Claims 1 to 10, wherein the current (128) comprises a charging current and is controlled in communication with a charging infrastructure.

12. The method according to one of Claims 1 to 11, wherein the current (128) comprises a recuperation current of an electrical retarder and is controlled by decreasing a brake power of the retarder while simultaneously increasing a brake power of a friction brake.

13. A traction energy storage system (100) of a vehicle, comprising:
a plurality of energy stores (102) which are able to be connected in parallel; and
at least one controller (802; 804) which exchanges signals with the vehicle and which is configured to perform or to control in each case the steps of one of Claims 1 to 12.

14. A motor vehicle, in particular a utility vehicle, having a traction energy storage system (100) according to Claim 13.

## Revendications

1. Procédé (200) permettant de faire fonctionner un système d'accumulation d'énergie de traction (100) d'un véhicule, comprenant plusieurs accumulateurs d'énergie (102) pouvant être connectés en parallèle, dans lequel un sous-ensemble (112) des accumulateurs d'énergie est connecté en parallèle et au moins un accumulateur d'énergie à mettre en circuit n'est pas connecté en parallèle avec le sous-ensemble connecté en parallèle, comprenant les étapes consistant à :
déterminer (202) une résistance interne (116) du sous-ensemble (112) connecté en parallèle des accumulateurs d'énergie, une tension en circuit ouvert (114) du sous-ensemble (112) connecté en parallèle des accumulateurs d'énergie et une tension en circuit ouvert (302) du au moins un accumulateur d'énergie à mettre en circuit ;
commander (204) un courant (128) à travers le sous-ensemble (112) connecté en parallèle des accumulateurs d'énergie qui est dimensionné de telle sorte que la tension en circuit ouvert (114) du sous-ensemble (112) connecté en parallèle des accumulateurs d'énergie et une chute de tension provoquée par le courant (128) et la résistance interne (116) produisent une tension (124) du sous-ensemble (112) connecté en parallèle des accumulateurs d'énergie qui dévie de la tension en circuit ouvert (302) du au moins un accumulateur d'énergie à mettre en circuit de moins d'une tension de commutation prédéterminée ;
connecter en parallèle (206) ledit au moins un accumulateur d'énergie à mettre en circuit avec le sous-ensemble (112) connecté en parallèle des accumulateurs d'énergie pendant que la tension (124) du sous-ensemble (112) connecté en parallèle des accumulateurs d'énergie dévie de la tension en circuit ouvert (302) du au moins un accumulateur d'énergie à mettre en circuit de moins de la tension de commutation prédéterminée ; et
déterminer un mode de fonctionnement du véhicule, dans lequel, dans un mode de fonctionnement prélevant principalement de l'énergie du système d'accumulation d'énergie de traction (100), la tension en circuit ouvert (114) du sous-ensemble (112) connecté en parallèle est supérieure à la tension en circuit ouvert (302) du au moins un accumulateur d'énergie à mettre en circuit, et/ou dans un mode de fonctionnant apportant principalement de l'énergie au système d'accumulation d'énergie de traction (100), la tension en circuit ouvert (114) du sous-ensemble (112) connecté en parallèle est inférieure à la tension en circuit ouvert (302) du au moins un accumulateur d'énergie à mettre en circuit,
**caractérisé en ce que** le courant (128) est commandé **en ce qu'**une puissance électrique absorbée et/ou débitée d'un consommateur auxiliaire relié au sous-ensemble (112) connecté en parallèle des accumulateurs d'énergie est modifiée.

2. Procédé selon la revendication 1, dans lequel la tension (124) du sous-ensemble (112) connecté en parallèle des accumulateurs d'énergie est appliquée à une interface de puissance (122) du système d'accumulateurs d'énergie de traction (100).

3. Procédé selon la revendication 2, dans lequel le courant commandé (128) passe par l'interface de puissance (122) du système d'accumulation d'énergie de traction (100).

4. Procédé selon la revendication 2 ou 3, dans lequel le courant commandé (128) passant à travers l'interface de puissance (122) du système d'accumulation d'énergie de traction (100) est différent de zéro avant, pendant et après la connexion en parallèle (206).

5. Procédé selon l'une quelconque des revendications 1 à 4, dans lequel l'exécution au moins des étapes de commande (204) et de connexion en parallèle (206) suppose que la tension en circuit ouvert (114) du sous-ensemble (112) connecté en parallèle dévie de la tension en circuit ouvert (302) du au moins un accumulateur d'énergie à mettre en circuit de moins d'une différence de tension en circuit ouvert prédéterminée, la différence de tension en circuit ouvert prédéterminée étant supérieure à la tension de commutation prédéterminée.

6. Procédé selon l'une quelconque des revendications 1 à 5, dans lequel l'étape de commande (204) régule la tension (124) du sous-ensemble (112) connecté en parallèle des accumulateurs d'énergie sur la tension en circuit ouvert (302) du au moins un accumulateur d'énergie à mettre en circuit.

7. Procédé selon la revendication 6, dans lequel l'étape de commande (204) régule la tension (124) du sous-ensemble (112) connecté en parallèle pendant une période de temps qui comprend l'étape de connexion en parallèle (206).

8. Procédé selon la revendication 7, dans lequel la période de temps est supérieure à 50 ms et/ou inférieure à 500 ms.

9. Procédé selon l'une quelconque des revendications 1 à 8, dans lequel le courant (128) est commandé en ce qu'un couple d'entraînement du véhicule, provoqué au moyen du courant, est modifié ou temporisé.

10. Procédé selon la revendication 9 en relation avec la revendication 7 ou 8, dans lequel le couple d'entraînement provoqué correspond en dehors de la période de temps à une demande du conducteur et/ou dévie pendant la période de temps d'une demande du conducteur.

11. Procédé selon l'une quelconque des revendications 1 à 10, dans lequel le courant (128) comprend un courant de charge et est commandé en communication avec une infrastructure de charge.

12. Procédé selon l'une quelconque des revendications 1 à 11, dans lequel le courant (128) comprend un courant de récupération d'un frein continu électrique et est commandé par une diminution d'une puissance de freinage du frein continu avec une temporisation simultanée d'une puissance de freinage d'un frein d'usure.

13. Système d'accumulation d'énergie de traction (100) d'un véhicule, comprenant :
plusieurs accumulateurs d'énergie (102) pouvant être connectés en parallèle ; et
au moins une commande (802 ; 804) en échange de signaux avec le véhicule et qui est réalisée pour exécuter ou commander respectivement les étapes d'une des revendications 1 à 12.

14. Véhicule automobile, en particulier véhicule utilitaire, comprenant un système d'accumulation d'énergie de traction (100) selon la revendication 13.
